# EUROPEAN PATENT APPLICATION

(11) **EP 0 624 957 A1**
(43) Date of publication of application: **17.11.1994**
(21) Application number: 94303443.9
(22) Date of filing: 13.05.1994
(51) Int. Cl.: H04B 1/18, H03G 1/00

(54) **Antenna input receiving circuit**

(30) Priority: 13.05.1993 JP 111419/93
(71) Applicant: KABUSHIKI KAISHA TOSHIBA, Kawasaki-shi, Kanagawa-ken 210 (JP)
(72) Inventor: Miyasaka, Toshiki, c/o Intel. Prop. Div., Minato-ku, Tokyo (JP)
(74) Representative: Muir, Ian R.

(57) **Abstract**

An antenna input receiving circuit, which is to be used in coupled between an antenna and at least one tuning circuit (5/7) for supplying the tuning circuit (5/7) with an RF signal received by the antenna (1), includes an active element (3a/3b) coupled between the antenna (1) and the tuning circuit (5/7) and a detector (19, 20) for detecting the electric field intensity of the RF signal received by the antenna (1) to control the conductance of the active element (3a/3b) in response to the detected electric field intensity.

## Description

The present invention relates to an antenna input receiving circuit for using in associated with TV receivers or the like to be used in vehicles.

In recent years, a competition for a miniaturization or a cost-cutting of car receiver equipments such as car TV receivers is becoming increasingly fierce. Thus many improvements of components or parts which are used for constructing the car receiver equipments has been increasingly required.

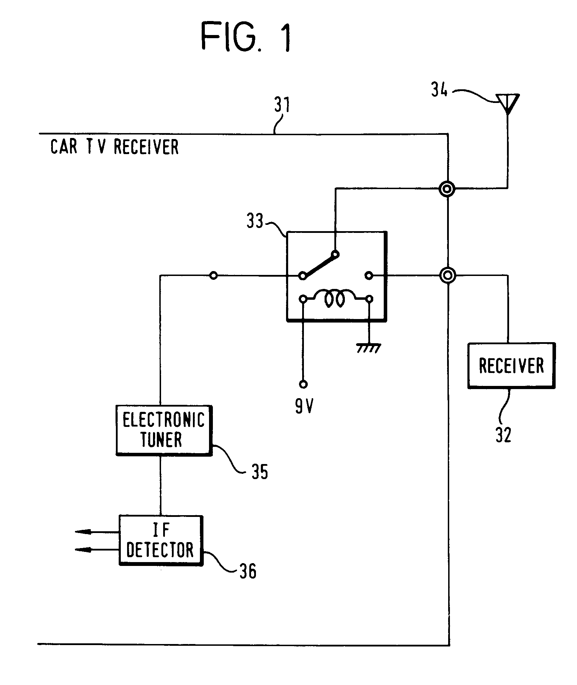

Referring now to FIGURE 1, a conventional car TV receiver will be explained.

As shown in FIGURE 1, a conventional car TV receiver 31 is typically mounted on a dash-board in vehicles together with a car radio receiver 32. An RF relay switch 33 is mounted at a section associated to the car TV receiver 31 as a part of an antenna input circuit, for selectively inputting RF signals received by an antenna 34 to another section associated to the car radio receiver 32 or the section associated to the car TV receiver 31.

The RF relay switch 33 has advantageously a very low insertion loss, so that the RF relay switch 33 is able to sufficiently isolate circuits coupled to the antenna with each other. Due to the above advantage, the RF antenna 33 has become widely used in recent years, in spite of the RF relay switch 33 being relatively expensive for processing the RF signals.

As though such car TV receivers are used in a state mounted in cars or vehicles as their name implies, the car TV receivers are so designed to be able to receive radio waves in the best condition even if the vehicle is moving. That is, an adequate receiving remedy is applied to receiving circuits such as an electronic tuner 35 or an IF detector 36 to obtain a stable receiving performance over a wide range of field intensity from a weak electric field input to a strong electric field input. It is therefore important to secure an interference rejection characteristic or an AGC characteristic for the car receiver equipments or the car TV receivers. Thus, the electronic tuner 33 is generally comprised of high-quality filters or high power gain ICs.

By the way, in recent years the competition of the miniaturization or the cost-cutting grows more and more intense at the market of the car TV receivers. Thus the miniaturization or the cost-cutting must be accomplished with maintaining basic performances of the receivers when they are newly put on the market.

However, in practical situations the miniaturization or the cost-cutting of the car TV receivers do not meet expectations of developers of the receivers, when the electronic tuner 35 is constructed in a large size or the RF relay switch 33 is constructed in a large size and in expensive.

As described above, the conventional antenna input receiving circuit has such problems that when an RF relay switch is used, the circuit becomes expensive in its cost and large in size for accomplishing a sufficient receiving performance.

### SUMMARY OF THE INVENTION

It is, therefore, an object of the present invention to improve the above problems in the conventional antenna input receiving circuits.

Another object of the present invention is to provide an antenna input receiving circuit capable of contributing for a miniaturization or a cost-cutting of a car receiver equipment by constructing the circuit by effective but inexpensive circuit components in place of RF relay switches.

In order to achieve the above object, an antenna input receiving circuit according to one aspect of the present invention, which is to be used in coupled between an antenna and at least one tuning circuits for supplying the tuning circuit with an RF signal received by the antenna, includes an active element coupled between the antenna and the plurality of tuning circuit and a detector for detecting the electric field intensity of the RF signal received by the antenna to control the conductance of the active element in response to the detected electric field intensity.

In the antenna input receiving circuit of the present invention constructed as above, the detector detects signal an intensity of a received electric field and controls conductances of the plural active elements in response to the detected field intensity. So, it becomes possible to select a suitable one of the plural tuning circuits without deteriorating RF signals received by the antenna.

That is, the antenna input receiving circuit by an inexpensive elements construction which contain the plural active element without using an expensive RF relay switch.

As a result of the prior arts the present invention will contribute to an miniaturization or cost-cutting of an on-vehicle equipment.

For a better understandings of the present invention and many of the attendant advantages thereof, reference will now be made by way of example to the accompanying drawings, wherein:
FIGURE 1 is a schematic block diagram showing a conventional receiving circuit of car TV receivers;
FIGURE 2 is a schematic circuit diagram showing a preferred embodiment of the receiving circuit arrangement of car TV receivers according to the present invention; and
FIGURE 3 is a graph showing the operating characteristics of PIN diodes used in the receiving circuit of FIGURE 2.

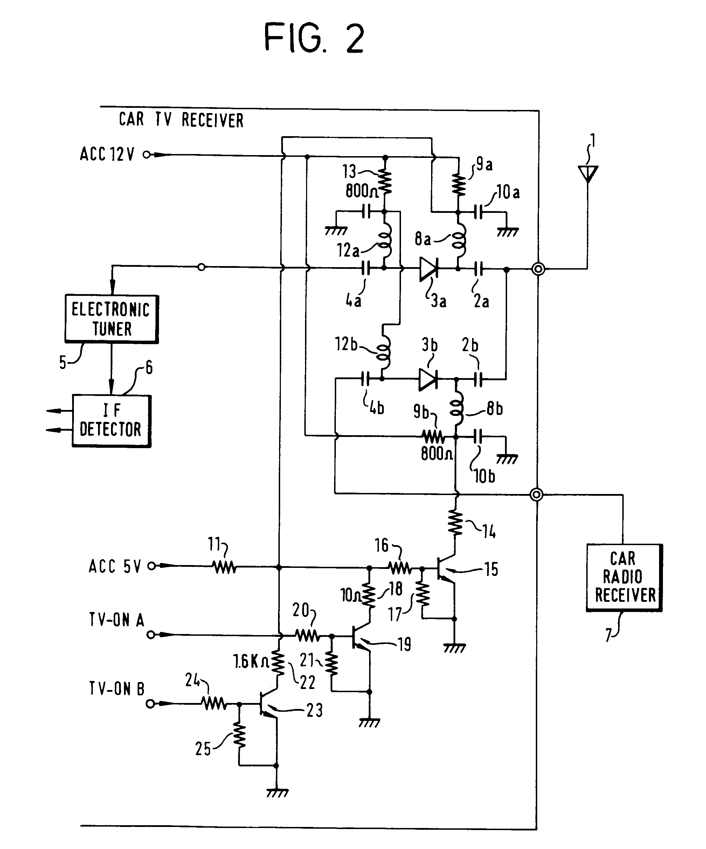

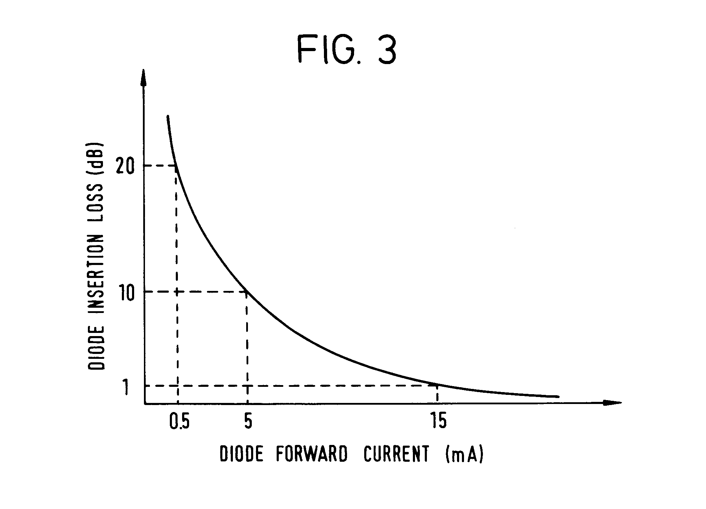

The present invention will be described in detail with reference to the attached drawings FIGURES 2 and 3.

Referring now to FIGURE 2, a first embodiment of the antenna input receiving circuit according to the present invention will be described in detail.

FIGURE 2 is a diagram showing a receiving circuit of a car TV receiver according to the present invention.

In FIGURE 2, the numeral 1 demotes an antenna connected to the receiving circuit. An electronic tuner 5 is connected to the antenna 1 via a capacitor 4a, a PIN diode 3a, and a capacitor 2a. An IF detector 6 is connected to the electronic tuner 5. Also a radio receiver 7 is connected to the antenna 1 via a capacitor 4b, a PIN diode 3b and a capacitor 2b in front of the capacitor 2a.

An accessory power supply source, which is referred as ACC, with a 12 V DC is coupled to the connecting node of the capacitor 2a and the PIN diode 3a via a resistor 9a and an inductor 8a. The connecting node of the capacitor 2a and the PIN diode 3a is grounded through a capacitor 10a.

Another ACC source with a 5 V DC is coupled to the connecting node of the inductor 8a and the resistor 9a via a resistor 11. The former ACC source with the 12 V DC is also coupled to the connecting node of the PIN diode 3a and the capacitor 4a via a resistor 13 and an inductor 12.

The former ACC source the 12 V DC is also coupled to the connecting node of the capacitor 2b and the diode 3b via a resistor 9b and an inductor 8b. The connecting node of the capacitor 2b and the PIN diode 3b is also grounded through a capacitor 10b. Still the former ACC source the 12 V DC is coupled to the connecting node of the capacitor 4b and the diode 3b via the resistor 13 and an inductor 12b.

The collector of a transistor 15, i.e., a first switching element is coupled to the connecting node of the inductor 8b and the resistor 9b via a resistor 14. The emitter of the transistor 15 is directly grounded. And the base of the transistor 15 is connected to the latter ACC source with the 5 V DC through a resistor 16 and the resistor 11. The base of the transistor 15 is also grounded through a resistor 17.

The collector of another transistor 19, i.e., a second switching element is connected to the latter ACC source with the 5 V DC through a resistor 18 and the resistor 11. The emitter of the transistor 19 is also directly grounded. The base of the transistor 19 is coupled to a terminal for receiving a first TV turn-on signal A via a resistor 20. The base of the transistor 19 is also grounded through a resistor 21.

The collector of still another transistor 23, i.e., a third switching element is connected to the latter ACC source with the 5 V DC through a resistor 22 and the resistor 11. The emitter of the transistor 23 is also directly grounded. The base of the transistor 23 is coupled to another terminal for receiving a second TV turn-on signal B via a resistor 24. The base of the transistor 23 is also grounded through a resistor 25.

Referring now to FIGURE 3, the operating characteristics of the PIN diodes 3a, 3b in the receiving circuit of FIGURE 1 will be explained.

As shown in FIGURE 3, forward currents flowing through the PIN diodes 3a, 3b and RF signals flowing through the PIN diodes 3a, 3b in the reverse direction from the antenna 1 are inversely proportioned to each other, thus causing attenuations, i.e., diode insertion losses of the RF signals to inversely proportion with the forward currents.

Based on the inverse proportion relationship as described above, the resistance of the resistor 18 is set to the 10 Ω so as that the current of 15 mA or more flows through the PIN diode 3a when the transistor 19 is turned on. Similarly, the resistance of the resistor 22 is set to the 1.6 kΩ so as that the current of 5 mA or more flows through the PIN diode 3a when the transistor 23 is turned on.

According to the above circuit condition, the levels of the RF signals on the inputs of the electronic tuner 5 and the radio receiver 7 are adequately regulated.

Thus the PIN diode 3a passes an RF signal therethrough without attenuating the RF signal when the transistor 19 is turned ON. While the PIN diode 3a attenuate the RF signal by 10 dB, when the transistor 23 is turned on.

When a main power switch (not shown) of the radio receiver 6 is turned on, the TV on-signals A, B are prevented from being applied to the transistors 19 and 23. Thus only the transistor 15 is turned on, while the transistors 19 and 23 are turned off. At this time, the PIN diode 3a is cut off but the and PIN diode 3b is made conductive. When the RF signal is received by the antenna 1, this RF signal is applied to the radio receiver 7 through the PIN diode 3b in the conductive state.

When a main power switch of the car TV receiver is turned on, one of the TV ON-signals A, B selected according to an electric field intensity at that time is applied to its corresponding one of the transistors 19, 23 together with the latter ACC source with the 5 V DC. In this case, a microcomputer (not shown) determines the intensity of the received electric field, based on an AGC signal (Automatic Gain Control signal) in the electronic tuner 5. When the microcomputer determines a low level state of the electric field intensity, i.e., a week electric field state, the TV on-signal A is activated and the TV on -signal B is deactivated. While when the microcomputer determines a high level state of the electric field intensity, the TV on-signal B is activated but the TV on-signal A is deactivated.

In case of the weak electric field, for instance, only the TV on-signal A is activated. Then, the transistor 19 is turned on but the transistor 15 is turned off. Therefore the PIN diode 3a becomes conductive (ON state), while the PIN diode 3b is cut off( state). At this time an RF signal received by the antenna 1 is applied to the electronic tuner 5 through the PIN diode 3a in an almost non-loss condition. Here in an illustrative embodiment, the resistor 13 has the resistance of 800 Ω, the resistor 18 has the resistance of 10Ω, which would mainly effect in response to the conductive state of the transistor 19.

While in case of the strong electric field, for instance, only the TV on-signal B is activated. Then, the transistor 23 is turned on but the transistor 19 is turned off. However, as the resistor 22 has a very high resistance up to 1.6 Ω, so that a current capable of flowing through the PIN diode 3a is reduce a very small amount of 5 mA. Then the RF signal passing through the PIN diode 3a is applied to the electronic tuner 5 with attenuated by about 10 dB. That is, the PIN diode 3a operates as an attenuator for the RF signal at the strong electric field condition.

In the embodiment of the present invention, the antenna input receiving circuit is constructed by using very inexpensive components such as the resistors 8a, 8b, 9a, 9b, 14, 18, 22, the capacitors 2a, 2b, 4a, 4b, and the PIN diodes 3a, 3b, rather than RF relays which are very expensive. However, this antenna input receiving circuit of the present invention is also effectively able to switch the RF signals to the electronic tuner 5 of the car TV receiver and the radio receiver 7 therebetween. Accordingly the present invention can contribute for the miniaturization and the cost-cutting of the car TV receiver.

Further in this antenna input receiving circuit of the present invention the electronic tuner 5 needs not to take any countermeasure against an excessively strong electric field other than the PIN diodes. Thus the electronic tuner 5 has very much got smaller and cheaper. This also results to contribute for smaller and cheaper car TV receivers.

As described above, the antenna input receiving circuit according to the present invention can contribute to the miniaturization and the cost-cutting of the car equipments which are able to switch the RF signal by an inexpensive circuit constructed by using some suitable active elements rather than expensive RF relay switches.

While there have been illustrated and described what are at present considered to be preferred embodiments of the present invention, it will be understood by those skilled in the art that various changes and modifications may be made, and equivalents may be substituted for elements thereof without departing from the true scope of the present invention.

For example, the present invention can be adapted for such a circuit which includes only one receiver, i.e., a car TV receiver or a car radio receiver. In a exemplified modification applied to the car TV receiver only, the part of circuit connection associated with the radio receiver 7 in FIGURE 2, e.g., the connection including the PIN diode 3b, the transistor 15, the resistors 9b and 14 to 17, the capacitors 2b, 4b and 10b, and the inductors 8b and 12b will be deleted.

On the other hand, the present invention an be easily expanded for such antenna input receiving circuit including a plularity of car receivers, i.e., three receivers or more.

In addition, many modifications may be made to adapt a particular situation or material to the teaching of the present invention without departing from the central scope thereof. Therefor, it is intended that the present invention not be limited to the particular embodiment disclosed as the best mode contemplated for carrying out the present invention, but that the present invention includes all embodiments falling within the scope of the appended claims.

The foregoing description and the drawings are regarded by the applicant as including a variety of individually inventive concepts, some of which may lie partially or wholly outside the scope of some or all of the following claims. The fact that the applicant has chosen at the time of filing of the present application to restrict the claimed scope of protection in accordance with the following claims is not to be taken as a disclaimer or alternative inventive concepts that are included in the contents of the application and could be defined by claims differing in scope from the following claims, which different claims may be adopted subsequently during prosecution, for example, for the purposes of a divisional application.

## Claims

1. An antenna input receiving circuit coupled between an antenna (1) and at least one tuning circuit (5/7), for supplying the tuning circuit (5/7) with an RF signal received by the antenna (1), characterized in that the antenna input receiving circuit is provided with:
an active element (3a/3b) coupled between the antenna (1) and the tuning circuit (5/7); and
means (19, 23) for detecting the electric field intensity of the RF signal received by the antenna (1) to control the conductance of the active element (3a/3b) in response to the detected electric field intensity.

2. An antenna input receiving circuit as claimed in claim 1, the active element (3a/3b) is a PIN diode.
